Europäisches Patentamt

European Patent Office

Office européen des brevets

(19)

(11) Numéro de publication : **0 112 217 B1**

(12) **FASCICULE DE BREVET EUROPÉEN**

(45) Date de publication du fascicule du brevet :
20.08.86

(51) Int. Cl.⁴ : **G 03 B 41/00**

(21) Numéro de dépôt : 83402275.8

(22) Date de dépôt : 25.11.83

(54) **Générateur de motifs pour circuits intégrés et procédé de génération de motifs utilisant ce générateur.**

(30) Priorité : 29.11.82 FR 8219997

(43) Date de publication de la demande :
27.06.84 Bulletin 84/26

(45) Mention de la délivrance du brevet :
20.08.86 Bulletin 86/34

(84) Etats contractants désignés :
DE FR GB IT NL

(56) Documents cités :
EP-A- 0 063 916
US-A- 3 632 205
IEEE TRANSACTIONS ON ELECTRON DEVICES, vol.
ED-28, no. 11, novembre 1981, pages 1416-1421, New
York, US M. NAKASE et al.: "Resolution and overlay
precision of a 10 to 1 step-and-repeat projection
printer for VLSI circuit fabrication"

(73) Titulaire : **CII HONEYWELL BULL**
**94 Avenue Gambetta**
**F-75990 Paris Cedex 20 (FR)**

(72) Inventeur : **Gueugnon, Catherine**
**22 rue Servandoni**
**F-75006 Paris (FR)**
Inventeur : **Bernstein, Pierre**
**8 Place Stalingrad**
**F-92190 Meudon (FR)**

(74) Mandataire : **Gouesmel, Daniel et al**
**94, avenue Gambetta**
**F-75020 Paris (FR)**

## Description

La présente invention concerne un générateur de motifs pour circuits intégrés et le procédé de génération de motifs utilisant ce générateur. Elle est plus particulièrement applicable à la fabrication des circuits à très haute intégration (souvent désignés par le sigle anglo-saxon VLSI) utilisés dans les circuits électroniques des systèmes de traitement de l'information.

Les techniques actuellement mises en œuvre pour réaliser les circuits électroniques des systèmes de traitement de l'information font de plus en plus appel à l'emploi de circuits intégrés dits à haute intégration VLSI. Ces circuits intégrés se présentent généralement sous la forme de petites plaquettes rectangulaires ou carrées dont les côtés mesurent quelques millimètres, plaquettes qui sont généralement appelées « puces » (chips en anglais). Dans la pratique courante, les technologies de fabrication utilisées permettent de disposer plusieurs dizaines de milliers de transistors à l'intérieur de chacune de ces puces, ainsi que leurs réseaux conducteurs d'interconnexion.

Pour simplifier, on peut définir un circuit intégré comme un empilement d'une pluralité de couches différentes sur un substrat de silicium. Ces différentes couches extrêmement minces peuvent être par exemple constituées d'oxyde de silicium, de verre phosphosilicate, de nitrure de silicium, de poly silicium, de semi-conducteurs, de couches métalliques d'aluminium. Sur un même substrat de silicium, on peut disposer, lors du procédé de fabrication des circuits intégrés, plusieurs puces physiquement distinctes les unes des autres. Ainsi, sur un substrat de silicium dont les dimensions sont sensiblement celles d'un disque ayant un diamètre de l'ordre de 120 millimètres, on peut réaliser plusieurs dizaines de puces ayant par exemple la forme de carrés de quelques millimètres de côté. Lorsque la fabrication de l'ensemble des puces disposées sur un même substrat est terminée, on sépare physiquement les puces les unes des autres, par exemple par sciage.

Pour élaborer chacune des couches d'une même puce, le procédé de fabrication de celle-ci comprend différentes étapes utilisant différentes techniques telles que : dépôt de matériau sur la couche, gravures, dopage de la couche, oxydation de la couche etc...

A chacune de ces différentes étapes, il est nécessaire de délimiter sur la couche de la puce que l'on est en train d'élaborer, une (ou plusieurs) zone géographique déterminée sur laquelle on définit une pluralité de motifs à représenter. Cette opération s'effectue au moyen d'une technique habituellement désignée sous le nom de photolithographie.

La technique de la photolitographie consiste d'abord à enduire la couche du circuit intégré que l'on cherche à traiter d'une résine photo sensible. On éclaire ensuite cette couche enduite de sa résine par un rayonnement lumineux approprié à travers soit un masque, soit un réticule portant la représentation de l'ensemble des motifs à reproduire sur la zone à traiter de la couche du circuit intégré que l'on cherche à élaborer. Cette dernière opération est actuellement désignée sous le nom « d'insolation ».

Lors de cette insolation, les zones éclairées de la résine subissent une transformation chimique. Il existe deux types de résines photo-sensibles, à savoir les résines positives et les résines négatives. Dans le cas des résines positives, on insole (on éclaire par le rayonnement lumineux) les zones que l'on cherche à traiter, soit par dépôts, soit par gravures, soit par oxydations etc...). Dans le cas des résines négatives, on insole les zones à protéger. Quel que soit le type de résine on dissout la résine des zones insolées dans un bain chimique approprié. Il est donc clair que les parties du matériau enduites de résine, qui n'ont pas été insolées restent protégées par la résine. On peut donc alors procéder aux différentes traitements physico chimiques appropriés mentionnés plus haut, à travers ce masque de résine.

Ainsi qu'il a été décrit plus haut, l'éclairage de la résine se fait à travers soit un masque, soit un réticule. Le masque est une représentation à l'échelle 1 des zones de la résine que l'on cherche à protéger. Lors de l'insolation, le masque est mis directement en contact avec la couche du circuit intégré enduite de résine.

Le réticule est une représentation à une échelle très supérieure à 1 (habituellement égale à 10) des motifs à reproduire sur la zone ou les zones à traiter de la couche enduite de résine. L'image de ce réticule est alors projetée en réduction (le rapport de réduction est égal à l'inverse de l'échelle précitée soit un dixième dans le cas où cette échelle est égale à 10) sur la couche enduite de résine.

On voit donc que, à une couche déterminée d'une puce (circuit intégré à très haute intégration) correspond au moins un réticule ou un masque.

En conclusion de ce qui précède, on voit qu'on peut engendrer des motifs sur des couches pour circuits intégrés, grâce à un ensemble de moyens qui sont les suivants :

une source émettrice de faisceau de lumière, (de longueur d'onde voisine du proche ultra-violet, par exemple)

pour chacune des couches du circuit intégré, au moins un réticule associé à celle-ci porteur de motifs à reproduire sur cette dernière, réticule transparent au faisceau lumineux envoyé par la source,

des moyens optiques de projection de l'image des motifs sur la couche de circuit intégré enduite de résine photosensible.

L'ensemble des moyens définis ci-dessus est appelé générateur de motifs pour circuits intégrés.

Le substrat porteur de puces est disposé sur une table insensible aux vibrations, munie d'un système permettant de déplacer le substrat, suivant deux degrés de liberté, à savoir suivant des axes OX et OY perpendiculaires. Cette table est munie d'un système de positionnement extrêmement précis, et équipé par exemple d'un interféromètre laser, (par exemple, du type de ceux fabriqués par la société HEWLETT PACKARD sous le N° 5501 A et décrits dans les notices techniques de ce constructeur). Le générateur de motifs, est disposé sur une machine munie d'un système d'alignement optique extrêmement fin, permettant, à partir de mires optiques spéciales, d'obtenir des précisions de positionnement de la puce sur laquelle on désire reproduire les motifs par rapport au générateur, de l'ordre de deux dixièmes de microns.

Généralement, dans la pratique courante, on réalise un réticule de la manière suivante. On dépose sur un substrat de verre (lequel doit être transparent au faisceau de lumière émis par la source), une couche de chrome que l'on enduit ensuite de résine électro-sensible. La définition d'une résine électro-sensible est strictement analogue à celle d'une résine photo-sensible, à cette différence près qu'elle subit une transformation chimique sous l'action d'un faisceau d'électrons et non plus sous l'action de la lumière.

Si la résine est positive, les motifs sont écrits par un faisceau d'électrons de manière à ce que les zones à traiter (celles constituant les motifs) soient soumises à ce faisceau, alros que si la résine est négative, les zones que l'on cherche à protéger sont soumises au faisceau d'électrons. La résine électro-sensible est ensuite révélée dans un bain chimique approprié, le chrome étant ensuite attaqué dans les parties qui ne sont plus protégées par la résine.

Lorsque le réticule est terminé, il est nécessaire de contrôler les motifs qui y ont été inscrits. Si pour une raison quelconque, il y a en un endroit déterminé, excès de chrome, celui-ci est vaporisé par un faisceau laser. Par contre, si en un endroit déterminé, il manque un motif de chrome, il faut reprendre en cet endroit tout le processus conduisant à l'écriture du motif par le faisceau d'électrons décrit plus haut. De la sorte, l'expérience montre que si l'écriture d'un réticule à l'aide d'un faisceau d'électron est rapide (une demi-heure) le contrôle de celui-ci est très long et peut prendre quelques jours ce qui rend cette dernière étape extrêmement coûteuse.

L'ensemble des étapes aboutissant à la génération de motifs sur une couche pour circuits à très haute intégration, qui vient d'être décrit ci-dessus, constitue un procédé de génération de motifs sur une couche pour circuits intégrés, dont les opérations successives essentielles sont rappelées sur le tableau en annexe I (fin de la description).

L'inconvénient majeur du générateur de motifs selon l'art antérieur ainsi que du procédé de génération qui l'utilise est donc le mode d'obtention du réticule.

Selon l'invention, on y remédie en remplaçant le réticule constitué par un dépôt de chrome sur un substrat de verre, par un réticule magnéto-optique ayant des propriétés magnéto-optiques par effet Faraday, des rappels sur les matériaux magnéto-optiques et sur l'effet Faraday étant effectués ci-dessous.

Parmi les matériaux magnétiques ayant des propriétés magnéto-optiques, on compte notamment les grenats à base de fer, yttrium et de terre rare (gadolinium, terbium...). Ces matériaux et leurs propriétés magnéto-optiques sont par exemple décrits dans l'article intitulé « Large stable magnetic domains », écrit par G.R. PULLIAM, W.E. ROSS, B. MACNEAL et R.S. BAILEY, publié dans le journal of Applied Physics 53(3) de Mars 1982 entre les pages 2754 à 2758. De tels matériaux sont transparents à la lumière. Pour tout grenat de ce type, et plus généralement, pour tout matériau magnéto-optique, l'effet magnéto-optique repose sur le principe d'interaction d'une lumière polarisée rectiligne avec l'état magnétique du grenat ou du matériau. Si cette interaction a lieu par transmission de la lumière à travers le matériau, l'effet magnéto-optique et dit « effet Faraday ». Si elle a lieu par réflexion, l'effet est dit « effet Kerr ». On se limitera dans la suite de cette description à considérer l'effet Faraday.

On rappelle qu'une lumière est polarisée de façon rectiligne dans le plan lorsque le vecteur champ électrique (et par suite le vecteur induction magnétique) conserve toujours la même direction dans le plan perpendiculaire à la direction de propagation du rayonnement. On définit le plan de polarisation comme le plan contenant la direction de propagation de la lumière et le vecteur champ électrique.

Cette interaction a pour conséquence la rotation du vecteur champ électrique dans le plan perpendiculaire à la direction de propagation (c'est-à-dire dans le plan de polarisation).

Pour observer cet effet magnéto-optique, on envoie un faisceau de lumière polarisée rectiligne (de préférence mono-chromatique), sur la surface du grenat magnéto-optique dont l'aimantation est généralement normale à cette surface (on dit que le grenat est à aimantation perpendiculaire). On observe qu'après avoir traversé la couche de grenat magnétique, le vecteur champ électrique de la lumière polarisée subit une rotation, dans le plan de polarisation, qu'on dit par convention égale à un angle $(-\theta)$ lorsque la lumière rencontre une zone du grenat où l'aimantation est dite négative (c'est-à-dire de même sens que celui de la propagation de la lumière), et égale à $(+\theta)$ lorsque la lumière polarisée traverse une zone où l'aimantation est positive (sens opposé à celui de la propagation de la lumière).

Pour écrire des motifs sur le réticule magnéto-optique, il suffit simplement d'écrire sur celui-ci, au moyen d'un transducteur magnétique ou thermo-magnétique du type de ceux utilisés couramment dans les mémoires à disques magnétiques, des domaines d'aimantation, par exemple positive, ayant la forme des motifs que l'on cherche à reproduire sur une couche donnée pour circuit à très haute intégration, le reste de la surface du réticule (hors motifs) ayant une aimantation négative.

On rappelle qu'un transducteur magnétique est généralement composé d'un circuit magnétique autour duquel est disposé un enroulement et qui comporte un entrefer.

On rappelle qu'un transducteur thermo-magnétique est constitué d'une part, d'une source ponctuelle de chaleur permettant d'élever localement la température du matériau magnétique au-dessus de son point de Curie ou de son point de compensation et d'autre part, d'un système créant un champ magnétique permanent d'intensité suffisante pour orienter l'aimantation de la partie préalablement chauffée, lors de son refroidissement.

Pour projeter l'image des motifs (constitués par les domaines magnétiques d'aimantation positive) du réticule sur la couche pour circuit à très haute intégration enduite de résine, on éclaire le réticule avec un faisceau de lumière polarisée. En traversant les domaines d'aimantation positive (les motifs) le vecteur champ électrique de la lumière subit une rotation égale à ($+ \theta$), alors que en traversant les zones du réticule extérieures au domaine constituant les motifs, le vecteur champ électrique de la lumière polarisée subit une rotation dans le plan de polarisation égale à ($- \theta$). Si l'on dispose entre le réticule et la couche du circuit intégré, un analyseur de lumière, constitué d'un cristal privilégiant une direction de propagation de celle-ci, disposé de façon que cette direction soit à 90° de la direction qu'occupe le vecteur champ électrique de la lumière transmise lorsque celle-ci a traversé un domaine magnétique d'aimantation négative, on recueille à la sortie de l'analyseur une lumière d'intensité nulle lorsque la lumière traverse un domaine d'aimantation négative, alors que l'on recueille une lumière d'intensité non nulle lorsque la lumière à traversé un domaine magnétique d'aimantation positive (un motif).

En d'autres termes, on voit que du fait de la présence de l'analyseur de lumière, tout se passe comme si les domaines d'aimantation positive seuls transmettaient la lumière. (Il est clair que l'analyseur pourrait être disposé d'une façon différente, de telle sorte que seuls des domaines d'aimantation négative transmettent la lumière). On voit donc, de ce fait, que l'on peut projeter l'image des domaines d'aimantation positive (des motifs) sur la couche pour circuits intégrés sur laquelle on cherche à reproduire ces motifs.

Selon l'invention, le générateur de motifs pour circuits intégrés composés d'un empilement de différentes couches, comprend :

une source émettrice de faisceau de lumière,

pour chacune des couches du circuit intégré, au moins un réticule associé porteur de motifs à reproduire sur celles-ci, transparent au faisceau lumineux de la source,

des moyens optiques de projection de l'image des motifs sur la couche enduite de résine photo-sensible.

Ce générateur est caractérisé en ce que, un polariseur de lumière étant associé à la source, le réticule comporte une couche mince de matériau magnéto-optique à aimantation perpendiculaire à sa surface, où les motifs sont constitués de domaines magnétiques de forme déterminée ayant une aimantation opposée au milieu magnétique qui les entoure, l'image des motifs étant restituée par un analyseur de lumière.

L'invention concerne également un procédé de génération de motifs sur une couche pour circuits intégrés qui comprend les opérations suivantes :

1. la réalisation d'un réticule, par dépôt d'une couche mince sur un support transparent à la lumière et écriture des motifs sur la couche mince ;

2. la vérification des motifs ainsi obtenus,

3. l'enduction de la couche pour circuits intégrés par de la résine photo-sensible,

4. la projection et la focalisation de l'image du réticule sur la couche pour circuits intégrés ;

5. le développement de l'image des motifs projetés sur la couche, dans un bain dissolvant les parties de la couche soumises à la lumière lors de la projection et la focalisation de l'image du réticule.

Ce procédé est caractérisé en ce que :

a) on dépose une couche mince de matériau magnéto-optique d'aimantation perpendiculaire à sa surface sur le support transparent à la lumière ;

b) l'écriture des motifs sur la couche mince est effectuée au moyen d'un transducteur magnétique ou thermomagnétique obtenant ainsi le réticule ;

c) la vérification des motifs ainsi obtenus est effectuée au moyen d'un transducteur magnétique ou d'un transducteur utilisant l'effet magnéto-optique ;

d) la restitution de l'image est effectuée au moyen d'un ensemble constitué d'un polariseur de lumière, du réticule et d'un analyseur de lumière.

D'autres caractéristiques et avantages de la présente invention apparaîtront dans la description suivante donnée à titre d'exemple non limitatif et en se référant aux figures annexées :

Sur ces figures :

La figure 1 est un schéma illustrant le principe des générateurs de motifs selon l'art antérieur ;

La figure 2 est une vue en perspective montrant un réticule sur lesquels sont disposés quelques motifs, appartenant à un générateur de motifs selon l'art antérieur ;

La figure 3 montre une couche de circuit intégré enduite de résine photo-sensible sur laquelle ont été reproduits les motifs représentés sur le réticule de la figure 2 ;

La figure 4 composée des figures 4a, 4b, 4c et 4d illustre les principales étapes d'un procédé de gravure sur couche d'un circuit intégré par photo-lithographie ;

La figure 5 composée des figures 5a, 5b, 5c illustre des rappels concernant l'effet magnéto-optique Faraday des grenats magnéto-optiques,

Les figures 6 et 7 sont des schémas de principe du générateur de motifs pour circuits intégrés selon l'invention,

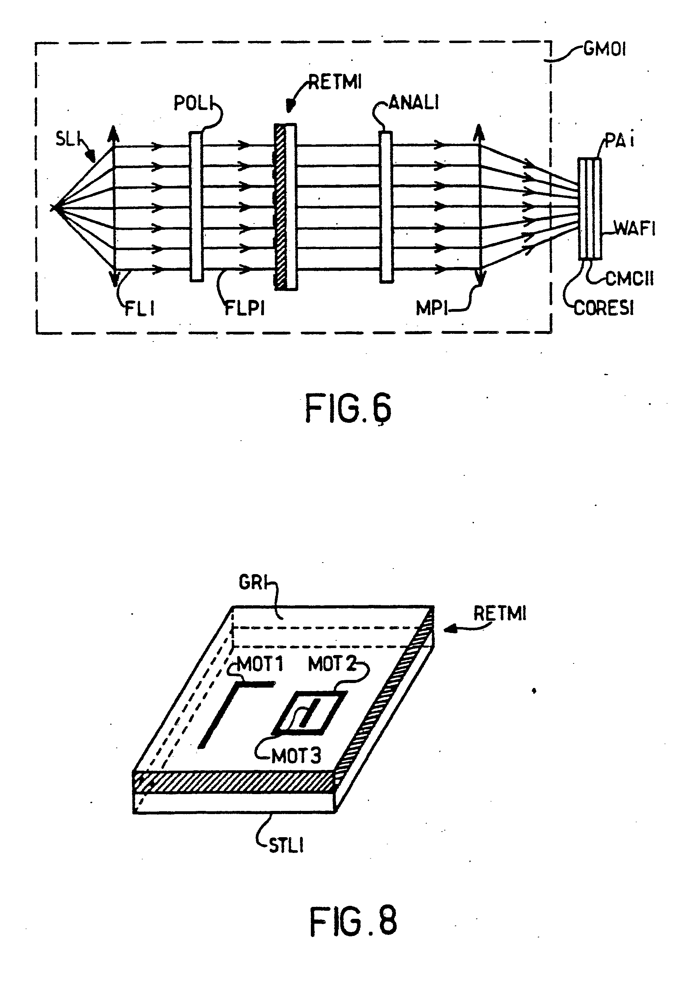

La figure 6 étant une vue de côté ;

La figure 7 étant une vue de trois-quarts en perspective.

La figure 8 est une vue en perspective montrant un réticule muni d'un certain nombre de motifs, appartenant au générateur de motifs selon l'invention ;

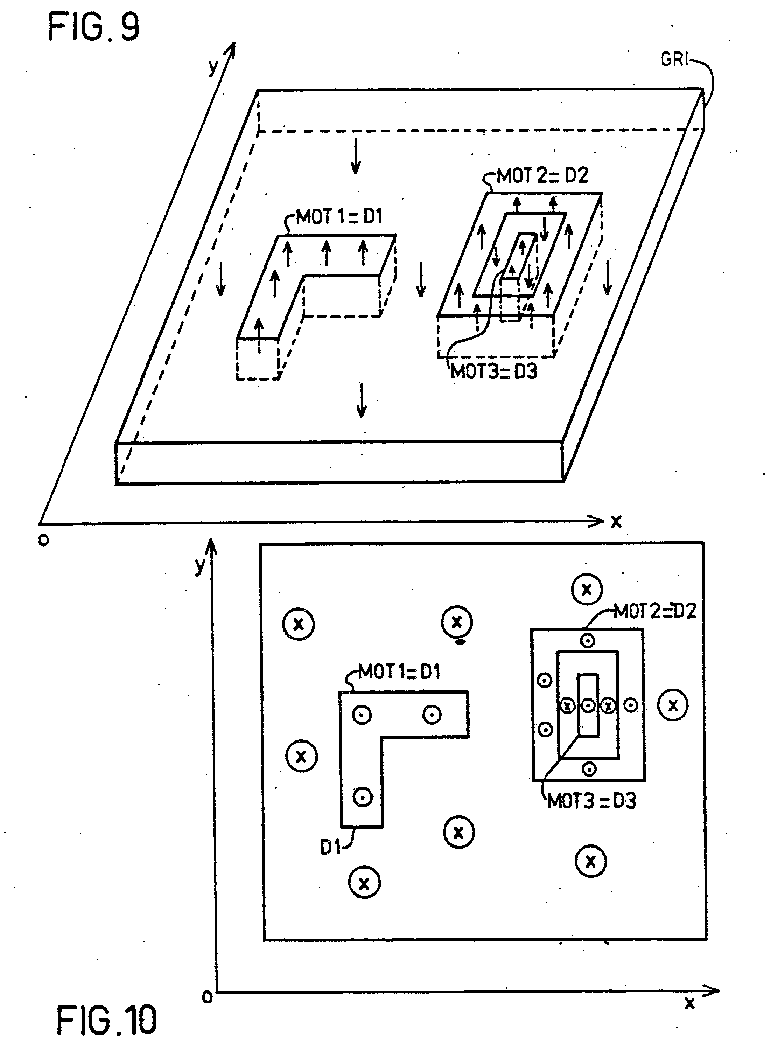

Les figures 9 et 10 montrent comment sont écrits les domaines magnétiques constituant les motifs sur le grenat magnéto-optique du réticule appartenant au générateur de motifs selon l'invention ;

La figure 9 étant une vue de trois-quarts en perspective ;

La figure 10 étant une vue de dessus.

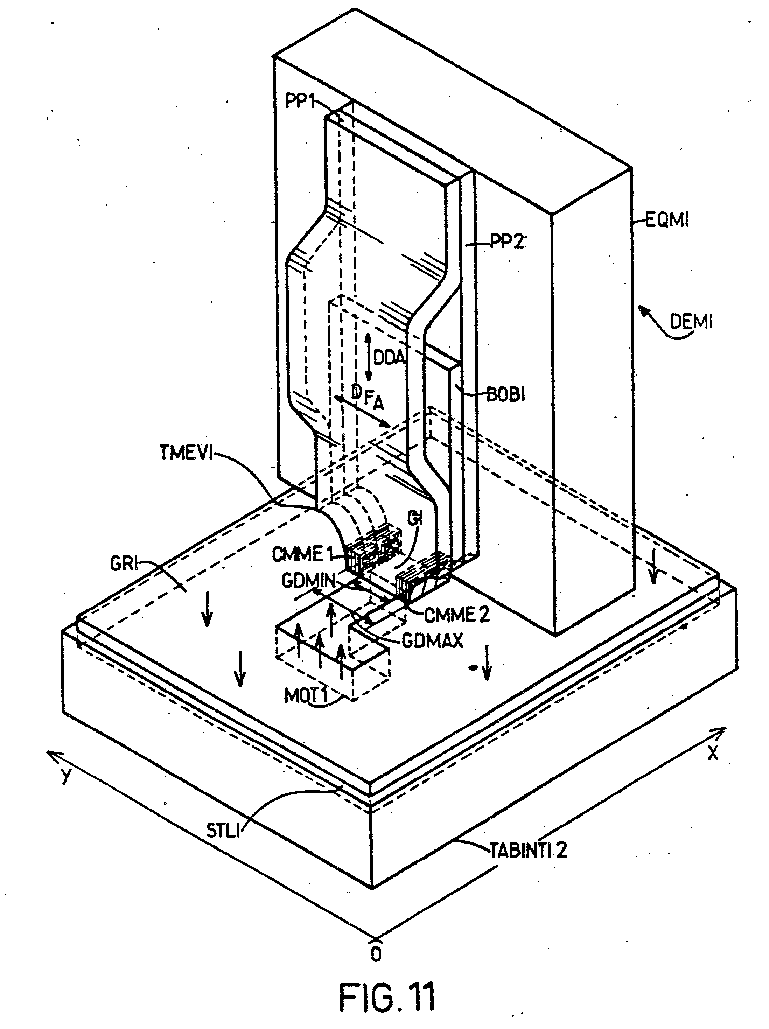

La figure 11 est une vue de trois-quarts en perspective montrant comment sont écrits les domaines magnétiques représentant les motifs sur le grenat magnéto-optique du réticule représenté aux figures 9 et 10, par un transducteur magnétique.

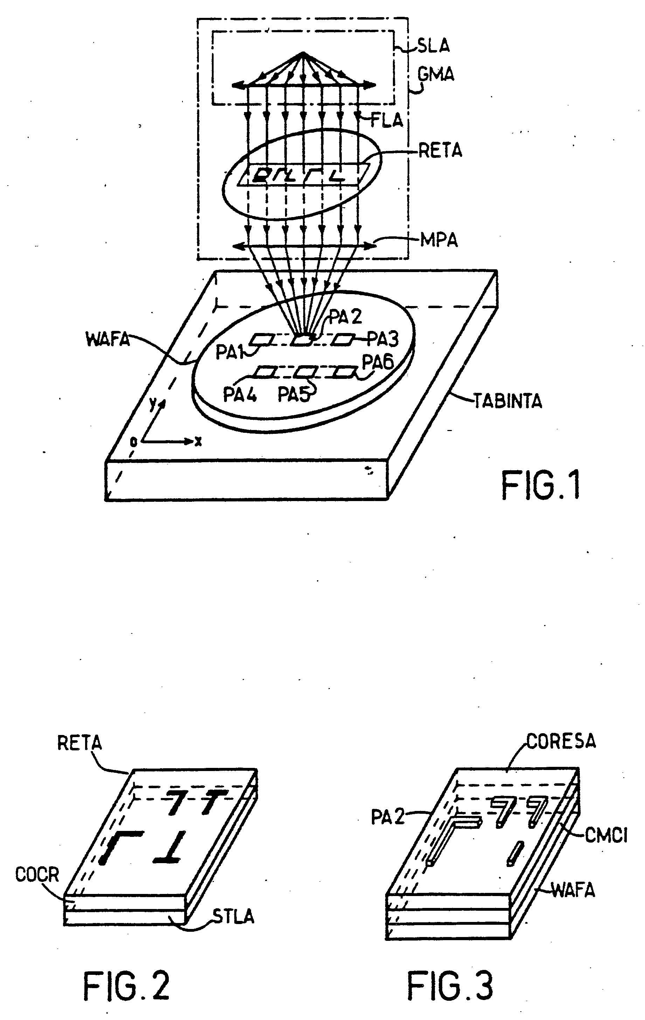

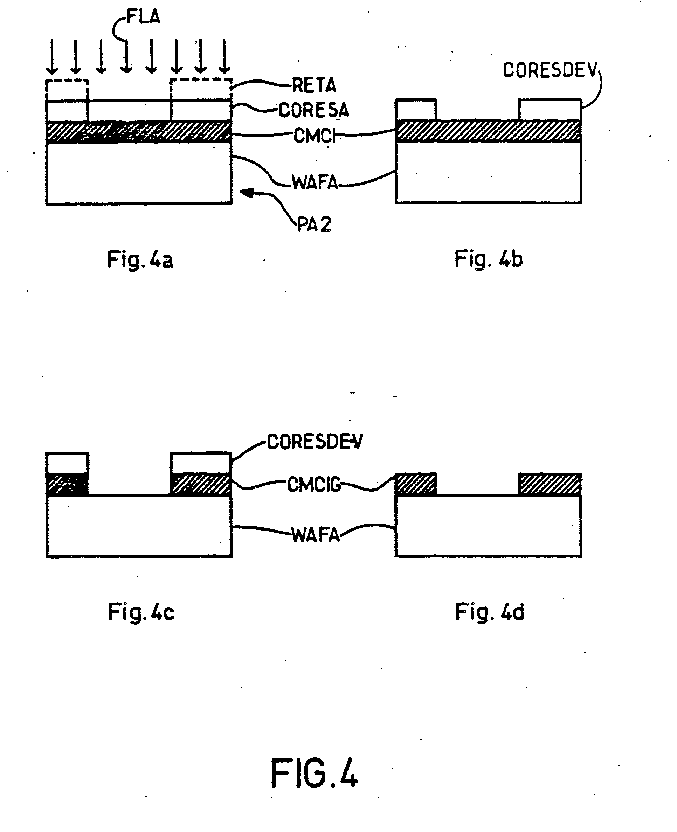

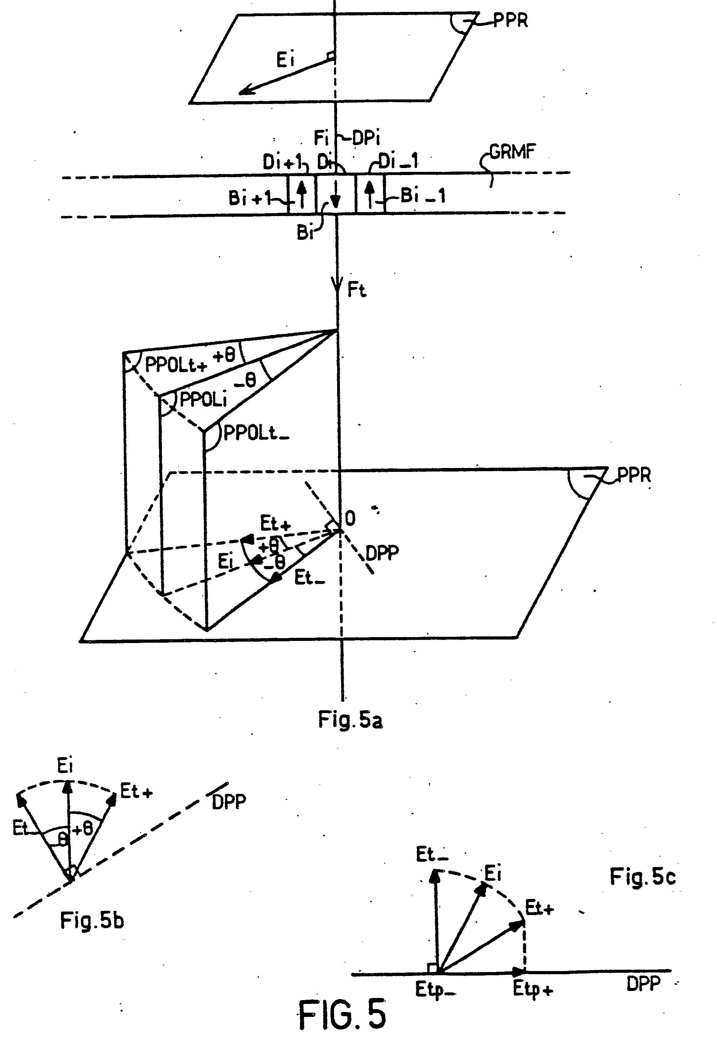

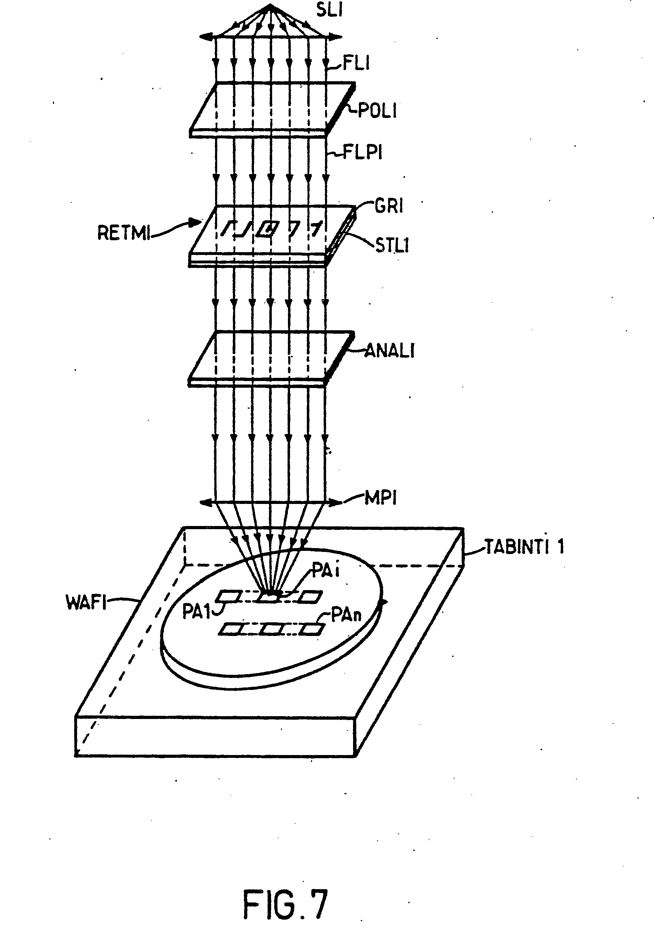

Afin de mieux comprendre les principes de constitution et de fonctionnement du générateur de motifs pour circuits intégrés selon l'invention, il est utile d'effectuer quelques rappels sur les générateurs de motifs selon l'art antérieur illustrés par les figure 1 et 2, sur les principes de la photo-lithographie, illustrés par les figures 3 et 4, et enfin sur l'effet Faraday des grenats magnéto-optiques illustrés par les figures 5a, 5b et 5c.

On considère la figure 1 qui représente des éléments constitutifs essentiels d'un générateur de motifs GMA selon l'art antérieur.

Ces éléments constitutifs sont les suivants :

une source de lumière SLA,

un réticule RETA,

des moyens de projection MPA de l'image des motifs portés par le réticule RETA sur une couche pour circuit intégré tel que l'une des puces PA1, PA2, à PA6 disposées sur un substrat de silicium WAFA.

Le substrat de silicium WAFA est disposé sur une table interférométrique TABINTA. La position de chacune des plaquettes PA1 à PA6 est repérée de manière extrêmement précise par un système de mesure interferométrique, par exemple équipé d'un interferomètre laser du type 5501A de la société HEWLETT PACKARD. Le repérage des puces s'effectue par rapport à un système d'axes rectangulaires OX, OY.

L'ensemble des éléments constituant le générateur de motifs d'une part, et le substrat de silicium muni de ses puces PA1 à PA6 d'autre part, sont alignés les uns par rapport aux autres par un système d'alignement optique extrêmement fin, à partir de mires optiques spéciales, la précision de l'alignement des puces par rapport au générateur étant de l'ordre de 2 dixièmes de micron.

Ainsi qu'on peut le voir à la figure 2, le réticule RETA comprend un support transparent à la lumière STLA par exemple un substrat de verre, sur lequel est déposée une couche mince de chrome COCR (la description du mode d'obtention d'un tel réticule est rappelée plus haut). On suppose que les motifs qui sont dessinés à la figure 2 ont été obtenus par attaque de la couche de chrome COCR ou par gravure de telle sorte qu'un faisceau de lumière puisse être transmis à travers ceux-ci.

Le fonctionnement du générateur de motifs selon l'art antérieur GMA est le suivant : La source de lumières LA émet un faisceau de lumière parallèle FLA. La lumière est transmise par les motifs du réticule RETA. Les moyens de projection MPA projettent l'image réduite des motifs sur l'une des puces disposée sur le substrat WAFA. Ainsi qu'on peut le voir à la figure 1, les images des motifs du réticule RETA sont projetées sur la puce PA2. Généralement le rapport de réduction entre les motifs du réticule et leurs images sur les puces PA1 à PA6 est de 1/10. L'image réduite des motifs du réticule RETA est projetée sur la couche de résine CORESA déposée préalablement sur la couche CMCI de la plaquette PA2, couche elle-même disposée sur le substrat en silicium WAFA. (Voir figure 3). Les différentes étapes d'obtention par gravure des motifs sur la couche CMCI de la puce PA2, au moyen d'un procédé photo-litographique, sont représentées aux figures 4a à 4d. Ces différentes étapes sont les suivantes :

a) insolation : le faisceau de lumière FLA passe à travers les motifs du réticule RETA et est transmis aux moyens de projection MPA qui en projettent l'image réduite sur la couche de résine CORESA enduisant la couche CMCI de la plaquette PA2 (figure 4A). Dans le cas où la résine CORESA est une résine positive, les parties de celle-ci qui sont insolées correspondent aux motifs que l'on cherche à reproduire sur la couche et qui sont ceux du réticule RETA.

b) développement : la couche de résine CORESA passe dans un bain chimique approprié où elle est révélée. Seules les parties qui ont été insolées (voir figure 4a) sont dissoutes par ce bain chimique. On obtient ainsi la couche de résine CORESDEV.

c) gravures des motifs : on grave, à travers le masque de résine CORESDEV la couche CMCI aux endroits qui ont été rappelés à la figure 4a. On obtient ainsi la couche gravée CMCIG.

d) dissolution de la résine : on dissout la résine dans un bain chimique. Une des couches constituant la puce PA2 est alors réalisée et on peut passer à l'étape suivante du procédé de fabrication de la puce.

On considère les figures 5a, 5b et 5c.

A la figure 5a on considère une couche mince (quelques microns à quelques dizaines de microns d'épaisseur) d'un grenat magnéto-optique GRMF à aimantation perpendiculaire c'est-à-dire où l'aimantation est normale à la surface de la couche. On a inscrit sur ce grenat un certain nombre de domaines magnétiques de faibles dimensions (quelques microns à quelques dizaines de microns), dont trois seulement ont été représentés à la figure 5a pour simplifier celle-ci. Ces domaines sont respectivement les domaines Di — 1, Di, Di + 1. Les vecteurs induction magnétique respectifs de chacun de ces domaines sont Bi — 1, Bi, Bi + 1. On envoie perpendiculairement à la surface du grenat GRMF un faisceau incident Fi de lumière polarisée rectiligne, selon une direction de la propagation DPi. Dans un plan de propagation PPR normal à la direction de propagation DPi, le champ électrique du faisceau incident Fi de lumière polarisée rectiligne, est Ei et à la direction indiquée aux figures 5a, 5b et 5c, les figures 5a et 5b étant des vues dans l'espace du plan PPR, alors que la figure 5c est une projection sur ce même plan PPR. On définit un plan de polarisation du faisceau de lumière Fi, il est défini par la direction de propagation DPi et le vecteur Ei (voir figure 5a), et est appelé PPOLi.

On suppose que le grenat magnéto-optique GRMF peut transmettre la lumière. Dans ces conditions, lorsque le faisceau de lumière polarisée rectiligne traverse le grenat GRMF, il devient le faisceau transmis Ft. Lorsque le faisceau Fi traverse un domaine magnétique d'aimantation négative, tel que le domaine Di, le faisceau transmis est tel que son champ électrique Et- a tourné d'un angle (— θ) par rapport au champ Ei du faisceau incident Fi. Le plan de polarisation du faisceau transmis Ft est alors PPOLt—, l'angle dièdre entre ce plan et le plan PPOLi étant aussi égal à (— θ).

De même lorsque le faisceau incident Fi traverse un domaine magnétique d'aimantation positive, tel que par exemple le domaine Di + 1 (Di — 1) d'induction Bi + 1, le faisceau transmis Ft est tel que son champ électrique Et+ subit une rotation (+ θ) par rapport au champ électrique Ei du faisceau incident Fi. Le plan de polarisation PPOLt + fait alors avec le plan PPOLi un angle dièdre égal à (+ θ).

La figure 5b permet de mieux voir les positions relatives des champs électriques Ei, Et—, Et+ des faisceaux Fi et Ft, selon que Fi traverse un domaine d'aimantation négative ou positive.

Afin de déterminer le sens de l'aimantation de chacun des domaines Di, ce qui revient à déterminer si le vecteur champ électrique a tourné d'un angle (— θ) ou d'un angle (+ θ) on place sur le chemin de propagation du faisceau transmis Ft, un élément analyseur de lumière. Celui-ci est généralement constitué d'un cristal présentant une direction privilégiée de transmission de la polarisation de la lumière, par exemple DPP, direction qui est représentée en traits pleins à la figure 5c. On place l'élément analyseur de telle sorte que cette direction privilégiée DPP soit normale au champ électrique Et—.

A la sortie de l'analyseur on recueille une lumière dont l'intensité lumineuse est proportionnelle au carré de la projection du vecteur champ électrique sur la direction provilégiée DPP. Ainsi si le faisceau Ft traverse un domaine d'aimantation négative, on recueillera à la sortie de l'analyseur une lumière d'intensité lumineuse proportionnelle au carré du module du vecteur Etp— projection du vecteur Et— sur la direction de polarisation DPP. De même, si le faisceau Ft traverse un domaine d'aimantation positive, (tel que Di + 1), on recueillera à la sortie de l'analyseur de lumière, une lumière dont l'intensité lumineuse est proportionnelle au carré du module du vecteur Etp+, projection du vecteur Et+ sur la direction DPP.

Ainsi on voit que si le faisceau Ft a traversé un domaine d'aimantation négative, on recueille à la sortie de l'analyseur une lumière d'intensité quasiment nulle alors que si le faisceau Ft a traversé un domaine d'aimantation positive, on recueille à la sortie de l'analyseur une lumière d'intensité non nulle.

Ainsi qu'il a été dit plus haut, le principal inconvénient des générateurs de motifs selon l'art antérieur est le fait que le mode de réalisation et de contrôle du réticule est long et coûteux. La présente invention permet de remédier à ces inconvénients en remplaçant le réticule du générateur de motifs selon l'art antérieur par un réticule magnéto-optique constitué par le dépôt d'une couche mince magnéto-optique à effet Faraday sur un substrat transparent à la lumière, par exemple une couche de grenat magnéto-optique dont les propriétés sont celles qui ont été rappelées ci-dessus et illustrées par les figures 5a, 5b et 5c.

Ainsi qu'on peut le voir aux figures 6 et 7, le générateur de motifs de circuits intégrés selon l'invention (GMOI) comprend les éléments suivants :

une source de lumière SLI,

un polariseur POLI,

un réticule magnéto-optique RETMI,

un analyseur de lumière ANALI,

des moyens de projection MPI de l'image des motifs du réticule RETMI sur une puce PAi disposée sur un substrat en silicium WAFI. Ce dernier est lui-même disposé sur une table interférométrique TABINTII du même type que la table interferométrique TABINTA montrée à la figure 1. Le substrat en silicium WAFI comprend n puces PA1, PA2, ....., PAi, .....PAn.

L'ensemble des éléments du générateur de motifs selon l'invention GMOI d'une part, et la table interferrométrique TABINTII d'autre part, sont montés de telle sorte qu'elles sont insensibles aux vibrations.

L'ensemble des éléments constituant le générateur de motifs GMOI d'une part et la puce PAi d'autre part, doivent être alignés les uns par rapport aux autres de manière extrêmement précise. Cet alignement est effectué au moyen d'un système d'alignement optique extrêmement fin permettant une précision d'alignement de deux dixièmes de microns environ.

Le réticule RETMI comprend, ainsi qu'on peut le voir à la figure 8, un grenat magnéto-optique par exemple, d'une épaisseur de quelques microns à quelques dizaines de microns, déposé sur un substrat transparent à la lumière STLI. Le grenat magnéto-optique GRI est à aimantation perpendiculaire à sa surface. On a représenté à la figure 8 quelques motifs MOT1, MOT2, MOT3 inscrits sur le grenat magnéto-optique, que l'on cherche à reproduire sur la puce PAi. Il est clair qu'au préalable, cette dernière a été enduite d'une couche de résine photo sensible CORESI.

Les propriétés que l'on requiert pour le grenat magnéto-optique GRI du réticule RETMI sont les suivantes :

avoir une forte rotation par effet Faraday (angle appelé — θ ou + θ à la figure 5) afin d'avoir à la sortie de l'analyseur ANALI, un très bon contraste de lumière entre la lumière transmise correspondant à un domaine d'aimantation négative et la lumière transmise correspondant à un domaine d'aimantation positive. Les matériaux magnétiques utilisés pour réaliser ces grenats peuvent avoir un effet Faraday donnant une rotation supérieure à 50 000 degrés/cm qui donne à la sortie de l'analyseur un contraste de lumière de 250 pour un grenat d'une épaisseur d'un micron : cela signifie que si la lumière transmise par un domaine d'aimantation négative à un coefficient d'intensité lumineuse de 1, la lumière transmise par un domaine d'aimantation positive a un coefficient de 250.

une faible absorption de la lumière, ce qui permet d'éviter l'échauffement du matériau et l'emploi de sources lumineuses trop puissantes,

la possibilité de réaliser ces grenats sur de grandes surfaces, de l'ordre de 100 × 100 millimètres,
une très faible densité de défauts.

Les figures 9 et 10 représentent plus en détail les trois motifs MOT1, MOT2 et MOT3 du grenat magnéto-optique GRI représenté à la figure 8. Ces trois motifs sont constitués par des domaines magnétiques D1, D2, D3 ayant les formes particulières indiquées sur ces mêmes figures 9 et 10. L'aimantation dans chacun des domaines D1, D2, D3 est orientée vers le haut et est donc supposée positive, alors que toute la surface du grenat GRI ne constituant pas les domaines (c'est-à-dire hors les domaines D1, D2, D3) a une aimantation magnétique orientée vers le bas, et par suite considérée comme négative.

Le fonctionnement du générateur de motifs selon l'invention GMOI est le suivant : La source de lumière SLI envoie un faisceau de lumière parallèle FLI qui en traversant le polarisateur POLI, est polarisée par ce dernier et devient le faisceau de lumière polarisée FLPI. Ce faisceau traverse le grenat magnéto-optique et subit une rotation de son plan de polarisation par effet Faraday égal à (— θ) s'il s'agit par exemple de domaines magnétiques d'aimantation négative (c'est-à-dire la surface du grenat GRI n'appartenant pas aux domaines magnétiques constituant les motifs) et subit une rotation (+ θ) en traversant les domaines où l'aimantation est positive, c'est-à-dire les domaines D1, D2, D3 constituant les motifs que l'on cherche à reproduire sur la puce PAi.

On suppose que l'analyseur ANALI est disposé de telle sorte que à sa sortie, la lumière qui a traversé les domaines d'aimantation négative a une intensité quasiment nulle, alors que la lumière transmise par les domaines d'aimantation positive a une intensité non nulle (le rapport entre les intensités dues respectivement à la traversée des domaines d'aimantation négative et positive est par exemple de l'ordre de 250, ainsi qu'il a été dit plus haut). On peut donc dire que l'analyseur ANALI restitue l'image des motifs D1, D2, D3.

Les moyens de projection MPI projettent une image réduite (le plus souvent à l'échelle 1/10) des motifs du réticule RETMI sur la couche de résine CORESI. La résine CORESI est donc isolée suivant les images des motifs MOT1, MOT2, MOT3 puis révélée. On peut alors effectuer sur la couche mince pour circuits intégrés CMCII de la puce PAi les opérations successives qui ont été décrites aux figures 4c et 4d.

On considère la figure 11 qui représente un exemple de réalisation d'un dispositif d'écriture de motifs DEMI destiné à inscrire les motifs sur un grenat magnéto-optique tel que GRI.

Ce dispositif DEMI comprend :
un transducteur magnétique d'écriture TMEVI,
un support du transducteur TMEVI en regard duquel peut se déplacer une table interferométrique TABINTI2 sur laquelle est disposé le grenat magnéto-optique GRI.

Le transducteur magnétique TMEVI est de préférence un transducteur magnétique de type intégré, analogue à celui décrit et revendiqué dans la demande de brevet 80.07453 déposée le 2 avril 1980 par la Compagnie Internationale pour l'Informatique CII Honeywell Bull sous le titre « Transducteur magnétique à entrefer de grande dimension variable pour la lecture et l'écriture d'informations contenues sur un support magnétique ». Ce transducteur TMEVI comprend une première pièce polaire PP1 et une seconde pièce polaire PP2, entre lesquelles est disposé un bobinage BOBI. Les pièces polaires PP1 et PP2 sont réalisées sous forme d'empilements de couches minces successives magnétiques et isolantes, alors que le bobinage BOBI est réalisé sous forme d'un empilement de couches minces successives conductrices et isolantes. Les deux pièces polaires PP1 et PP2 sont couplées magnétiquement à leur extrémité la plus éloignée du grenat magnéto-optique GRI, et sont disposées à l'autre extrémité la plus voisine de ce grenat magnéto-optique sensiblement perpendiculairement à celui-ci pour y former l'entrefer. Le transducteur comprend deux couches minces d'entrefer CMME1 et CMME2 dont les propriétés magnétiques sont telles que, suivant l'intensité du courant que l'on fait circuler dans le bobinage BOBI, l'entrefer a une grande dimension variant entre une valeur minimum GDMIN et une valeur maximum GDMAX.

De préférence, les pièces polaires PP1 et PP2 sont en matériau anisotrope ayant une direction de facile aimantation DFA et une direction de difficile aimantation DDA.

Pour écrire des domaines représentant les motifs à reproduire sur la puce PAi, tels que les domaines D1, D2, D3 représentés aux figures 8, 9, 10, on envoie par exemple un courant d'intensité positive dans le bobinage BOBI et approprié à la largeur des traits des motifs que l'on cherche à tracer sur la couche CMCII. Ces motifs s'enregistrent sous forme de domaines à aimantation positive.

Au contraire si l'on veut donner au grenat magnéto-optique GRI une aimantation négative (c'est-à-dire en dehors des motifs que l'on cherche à reproduire), on fait passer dans le bobinage BOBI du transducteur TMEVI un courant d'intensité négative.

Il est clair que, une fois les domaines D1 à D3 écrits sur le grenat GRI, il est extrêmement simple de vérifier si ceux-ci ont été correctement écrits, c'est-à-dire si ils ont été écrits aux endroits voulus, avec les dimensions voulues. Cette vérification peut être effectuée au moyen d'un transducteur approprié magnétique ou magnéto-optique.

On voit donc immédiatement l'avantage du réticule magnéto-optique utilisé dans les générateurs de motifs selon l'invention, à savoir un mode de réalisation technologique relativement simple, et des opérations d'écriture et de vérification des motifs extrèment simples, donc peu coûteuses et que l'on peut effectuer avec un transducteur magnétique ou thermo-magnétique de type courant pour l'écriture et avec un transducteur magnétique ou magnéto-optique de type courant pour la vérification.

On peut déduire aisément de ce qui précède la suite des opérations constituant le procédé de génération de motifs utilisant le générateur de motifs selon l'invention. Ces différentes opérations sont résumées sur le tableau en annexe II (après la description). On pourra comparer ce tableau (annexe II) avec le tableau (annexe I), constater la plus grande simplicité du procédé de génération de motifs utilisant le générateur de motifs selon l'invention par rapport au procédé de génération de motifs selon l'art antérieur.

Procédé de génération de motifs sur une couche pour circuit intégré selon l'art antérieur

Annexe I

Première opération : Réalisation d'un réticule :

a) par dépôt d'une couche mince sur un support transparent à la lumière (par exemple cette couche est en chrome) ;
b) par dépôt d'une résine électrosensible sur la couche en chrome ;
c) écriture des motifs sur le réticule par un faisceau d'électrons ;
d) révélation de la résine dans un bain chimique approprié ;
e) attaque du chrome là où la résine a été dissoute dans le bain chimique.

Deuxième opération : Vérification des motifs obtenus :

a) en cas de trait manquant, il est nécessaire de reprendre le processus de génération de motifs à la première opération, par dépôt d'une nouvelle couche de chrome.
b) S'il y a un trait en trop, on le fait disparaître en l'éclairant par un faisceau de lumière laser à haute énergie ;
c) lorsque le réticule est correct on passe à la troisième opération.

Troisième opération : Enduction de la couche du circuit intégré de résine photosensible.

Quatrième opération : Projection de l'image du réticule sur la couche pour circuit intégré enduite de résine.

Cinquième opération : Révélation de l'image des motifs projetés sur la résine protégeant la couche du circuit intégré par dissolution des parties de la résine soumise à la lumière lors de la quatrième opération.

Procédé de génération de motifs sur une couche pour circuit intégré selon l'invention

Annexe II

Première opération : Réalisation du réticule magnéto-optique par dépôt d'une couche de grenat magnéto-optique sur un support transparent à la lumière et écriture des motifs sur le réticule au moyen d'un transducteur magnétique, ou thermo-magnétique d'écriture.

Deuxième opération : Vérification des motifs du réticule au moyen d'un transducteur magnétique ou utilisant l'effet magnéto-optique.

En cas de trait manquant, il est aisé de le réécrire par le transducteur d'écriture utilisé plus haut.

en cas de trait supplémentaire, on l'efface au moyen du même transducteur d'écriture (en envoyant dans la bobine de celui-ci un courant inverse de celui avec lequel avait été écrit le trait supplémentaire).

Troisième opération : Identique à la troisième du tableau de l'annexe I selon l'art antérieur.

Quatrième opération : La restitution et la projection de l'image du réticule sur la couche pour circuit intégré sont effectuées au moyen d'un ensemble comprenant une source de lumière polarisée, un analyseur de lumière et des moyens de projection.

Cinquième opération : Analogue à la cinquième du tableau de l'annexe I, selon l'art antérieur.

**Revendications**

1. Générateur de motifs pour circuit intégré composé d'un empilement de différentes couches, comprenant :

une source (SLI) émettrice d'un faisceau de lumière,

pour chacune des couches du circuit intégré, au moins un réticule (RETMI) associé porteur de motifs à reproduire sur celle-ci, transparent sur au moins une partie de sa surface au faisceau lumineux de la source,

des moyens (MPI) optiques de projection de l'image des motifs sur la couche enduite de résine photo-sensible,

caractérisé en ce que, un polarisateur (POLI) de lumière étant associé à la source, le réticule (RETMI) comporte une couche mince de matériau magnéto-optique d'aimantation perpendiculaire à sa surface, où les motifs sont constitués de domaines magnétiques (D1, D2, D3) de forme déterminée ayant une aimantation déterminée et opposée au milieu magnétique qui les entoure, l'image des motifs étant restituée par un analyseur de lumière (ANALI).

2. Générateur selon la revendication 1 caractérisé en ce que le matériau magnéto-optique est un grenat (GRI) constitué de fer, yttrium et terre rare.

3. Procédé de génération de motifs sur une couche de circuits intégrés, comprenant successivement :

la réalisation d'un réticule (RETMI), par dépôt d'une couche mince sur un support transparent à la lumière et écriture des motifs (MOT1, MOT2, MOT3) sur la couche mince,

la vérification des motifs ainsi obtenus,

l'enduction de la couche de circuit intégré (CMCI) par une résine photo-sensible, (CORESI),

la projection et la focalisation de l'image du réticule sur la couche,

le développement de l'image des motifs projetés sur la couche, dans un bain dissolvant les parties de la couche soumises à la lumière lors de la projection et la focalisation de l'image du réticule, caractérisé en ce que :

a) on dépose une couche mince de matériau magnéto-optique (GRI) à aimantation perpendiculaire à sa surface sur le support transparent à la lumière (STLI),

b) l'écriture des motifs sur la couche mince de matériau magnéto-optique est effectuée au moyen d'un transducteur magnétique ou thermo-magnétique, obtenant ainsi le réticule (RETMI) ;

c) la vérification des motifs ainsi obtenus est effectuée par un transducteur magnétique ou magnéto-optique,

d) la projection est effectuée au moyen d'un ensemble constitué d'un polarisateur de lumière (POLI), du réticule (RETMI), et d'un analyseur de lumière (ANALI).

4. Réticule de générateur de motifs pour circuit intégré, porteur de motifs (MOT1, MOT2, MOT3) à reproduire sur au moins une couche (CMCII) du circuit, et transparent à la lumière sur au moins une partie de sa surface, caractérisé en ce qu'il comprend une couche mince de matériau magnéto-optique d'aimantation perpendiculaire à sa surface, où les motifs sont constitués de domaines magnétiques (D1, D2, D3) de forme déterminée ayant une aimantation déterminée et opposée à celle du milieu magnétique qui les entoure.

5. Réticule selon la revendication 4 caractérisé en ce que le matériau magnéto-optique est un grenat constitué de fer, yttrium et terre rare.

6. Procédé de réalisation d'un réticule de générateur de motifs pour circuit intégré obtenu par dépôt d'une couche mince sur un support (STLI) transparent à la lumière, caractérisé en ce que :

a) on dépose une couche mince de matériau magnéto-optique (GRI) à aimantation perpendiculaire à sa surface sur le support transparent à la lumière (STLI) ;

b) on écrit les motifs (MOT1, MOT2, MOT3) sur la couche mince de matériau magnéto-optique au moyen d'un transducteur magnétique (TMEVI) ou thermo-magnétique ;

c) on vérifie les motifs (MOT1, MOT2, MOT3) ainsi obtenus au moyen d'un transducteur magnétique ou magnéto-optique.

9

## Claims

1. Pattern generator for integrated circuits consisting of a stack of different layers, comprising :
a source (SLI) emitting a light beam,
for each of the layers of the integrated circuit, at least one associated reticle (RETMI) carrying patterns which are to be reproduced on the same, which is transparent to the light beam of the source over at least part of its surface,
, optical means (MPI) for projecting the image of the patterns on to the layer coated with photosensitive resin,
characterised in that, a light polariser (POLI) is associated with the source, the reticle (RETMI) comprises a thin layer of magneto-optical material magnetised perpendicular to its surface, on which the patterns are formed by magnetic areas (D1, D2, D3) of specific form having a magnetisation which is determined and opposed to the surrounding magnetic environment, the image of the patterns being reconstituted by means of a light analyser (ANALI).

2. Generator according to claim 1, characterised in that the magneto-optical material is a garnet (GRI) formed from iron, yttrium and rare earth.

3. Process for generating patterns on an integrated circuit layer, comprising in succession :
the forming of a reticle (RETMI) by depositing a thin layer on a carrier transparent to light and the production of the patterns (MOT1, MOT2, MOT3) on the thin layer,
the checking of the patterns thus obtained,
the coating of the integrated circuit layer (CMCI) with a photosensitive resin (CORESI),
the projection and focussing of the image of the reticle on to the layer,
the development of the image of the patterns projected on to the layer in a bath dissolving the parts of the layer exposed to light during the projection and focussing of the image of the reticle, characterised in that :
a) a thin layer of magneto-optical material (GRI) magnetised perpendicular to its surface is deposited on the carrier transparent to the light (STLI),
b) the production of the patterns on the thin layer of magneto-optical material is performed by means of a magnetic or thermo-magnetic transducer, thus obtaining the reticle (RETMI),
c) the checking of the patterns thus obtained is performed by means of a magnetic or magneto-optical transducer,
d) the projection is performed by means of an assembly comprising a light polariser (POLI), the reticle (RETMI) and a light analyser (ANALI).

4. Reticle of a pattern generator for integrated circuits, carrying patterns (MOT1, MOT2, MOT3) which are to be reproduced on at least one layer (CMCII) of the circuit, and transparent to light over at least a part of its surface, characterised in that it comprises a thin layer of magneto-optical material magnetised perpendicular to its surface, on which the patterns are formed by magnetic areas (D1, D2, D3) of specific shape, having a magnetisation which is determined and opposed to that of the magnetic environment surrounding them.

5. Reticle according to claim 4, characterised in that the magneto-optical material is a garnet formed by iron, yttrium and rare earth.

6. Process for producing a reticle of a pattern generator for integrated circuits obtained by depositing a thin layer on to a carrier (STLI) transparent to light, characterised in that :
a) a thin layer of magneto-optical material (GRI) magnetised perpendicular to its surface is deposited on the carrier transparent to light (STLI) ;
b) the patterns (MOT1, MOT2, MOT3) are produced on the thin layer of magneto-optical material by means of a magnetic or thermo-magnetic transducer (TMEVI) ;
c) the patterns (MOT1, MOT2, MOT3) thus obtained are checked by means of a magnetic or magneto-optical transducer.

## Patentansprüche

1. Mustergenerator für eine aus einem Stapel verschiedener Schichten zusammengesetzte integrierte Schaltung, enthaltend :
eine ein Lichtbündel aussendende Quelle (SLI),
für jede Schicht der integrierten Schaltung wenigstens eine zugeordnete Projektionsvorlage (RETMI), welche die darauf zu reproduzierenden Muster trägt und wenigstens auf einem Teil ihrer Oberfläche für das Lichtbündel aus der Quelle durchlässig ist,
optische Projektionsmittel (MPI) zur Projektion des Bildes der Muster auf der genannten, mit photoempfindlichem Harz überzogenen Schicht,
dadurch gekennzeichnet, daß die Projektionsvorlage (RETMI), wenn ein Lichtpolarisator (POLI) der Quelle zugeordnet ist,
eine dünne Schicht aus einem magnetooptischen Material mit einer zu ihrer Oberfläche senkrechten Magnetisierung umfaßt, worin die Muster aus Magnetgebieten (D1, D2, D3) von bestimmter Form gebildet sind, die eine bestimmte Magnetisierung aufweisen, welche entgegengesetzt zu der des sie umgebenden magnetischen Mediums ist, wobei das Bild der Muster durch einen Lichtanalysator (ANALI) wiederhergestellt wird.

2. Generator nach Anspruch 1, dadurch gekennzeichnet, daß das magnetooptische Material ein Granat (GRI) ist, welcher aus Eisen, Yttrium und seltener Erde besteht.

3. Verfahren zur Erzeugung von Mustern auf einer Schicht von integrierten Schaltungen, nacheinander umfassend :

die Herstellung einer Projektionsvorlage (RETMI) durch Ablagerung einer dünnen Schicht auf einem lichtdurchlässigen Träger und das Aufzeichnen der Muster (MOT1, MOT2, MOT3) auf der dünnen Schicht,

die Überprüfung der so erhaltenen Muster,

Überziehen der Schicht der integrierten Schaltung (CMCI) mit einem photoempfindlichen Harz (CORESI),

die Projektion und Fokussierung des Bildes der Projektionsvorlage auf der Schicht,

die Entwicklung des Bildes der auf die Schicht projizierten Muster in einem Bad, welches diejenigen Teile der Schicht auflöst, die während der Projektion und Fokussierung des Bildes der Projektionsvorlage belichtet wurden, dadurch gekennzeichnet, daß :

a) eine dünne Schicht aus magnetooptischem Material (GRI) mit einer zu ihrer Oberfläche senkrechten Magnetisierung auf dem lichtdurchlässigen Träger (STLI) aufgebracht wird,

b) das Aufzeichnen der Muster auf der dünnen Schicht aus magnetooptischem Material mittels eines magnetischen oder thermomagnetischen Wandlers geschieht, um auf diese Weise die Projektionsvorlage (RETMI) zu erhalten ;

c) die Überprüfung der so erhaltenen Muster mittels eines magnetischen oder magnetooptischen Wandlers durchgeführt wird,

d) die Projektion mittels einer Gruppe durchgeführt wird, die aus einem Lichtpolarisator (POLI), der Projektionsvorlage (RETMI) und einem Lichtanalysator (ANALI) besteht.

4. Projektionsvorlage für einen Mustergenerator für integrierte Schaltung, als Träger von Mustern (MOT1, MOT2, MOT3), die auf wenigstens einer Schicht (CMCII) der Schaltung zu reproduzieren sind, und auf wenigstens einem Teil ihrer Oberfläche lichtdurchlässig, dadurch gekennzeichnet, daß sie eine dünne Schicht aus magnetooptischem Material mit einer zu ihrer Oberfläche senkrechten Magnetisierung enthält, worin die Muster aus Magnetgebieten (D1, D2, D3) von bestimmter Form gebildet sind, die eine bestimmte Magnetisierung aufweisen, welche entgegengesetzt zu derjenigen des sie umgebenden magnetischen Mediums ist.

5. Projektionsvorlage nach Anspruch 4, dadurch gekennzeichnet, daß das magnetooptische Material ein Granat aus Eisen, Yttrium und seltener Erde ist.

6. Verfahren zur Herstellung einer Projektionsvorlage eines Mustergenerators für integrierte Schaltung, erhalten durch Ablagern einer dünnen Schicht auf einem lichtdurchlässigen Träger (STLI), dadurch gekennzeichnet, daß :

a) eine dünne Schicht aus magnetooptischen Material (GRI) mit einer zu ihrer Oberfläche senkrechten Magnetisierung auf dem lichtdurchlässigen Träger (STLI) aufgebracht wird ;

b) die Muster (MOT1, MOT2, MOT3) auf der dünnen Schicht aus magnetooptischem Material mittels eines magnetischen oder thermomagnetischen Wandlers (TMEVI) aufgezeichnet werden ;

c) die so erhaltenen Muster (MOT1, MOT2, MOT3) mittels eines magnetischen oder magnetooptischen Wandlers überprüft werden.

11

FIG.1

FIG.2

FIG.3

FLA

RETA

CORESA

CMCI

WAFA

PA2

Fig. 4a

CORESDEV

Fig. 4b

CORESDEV

CMCIG

WAFA

Fig. 4c

Fig. 4d

FIG.4

Fig.5a

Fig.5b

Fig.5c

FIG.5

FIG.7

FIG.6

FIG.8

# FIG.9

MOT 2 = D2

MOT 1 = D1

MOT3 = D3

GRI

# FIG.10

MOT 2 = D2

MOT 1 = D1

MOT3 = D3

D1

0 112 217

FIG. 11